# EUROPEAN PATENT APPLICATION

(11) **EP 1 037 308 A1**
(43) Date of publication of application: **20.09.2000**
(21) Application number: 99105594.8
(22) Date of filing: 18.03.1999
(51) Int. Cl.: H01Q 23/00

(54) **Electric filter for filtering low frequencies**

(71) Applicant: TELEFONAKTIEBOLAGET LM ERICSSON, 126 25 Stockholm (SE)
(72) Inventor: Kodim, Walter, 90489 Nürnberg (DE); Janker, Reinhard, 91085 Weisendorf (DE); Iveberg, Staffan, 22241 Lund (SE); Gustavsson, Johan, 22240 Lund (SE)
(74) Representative: Mohsler, Gabriele

(57) **Abstract**

The invention relates to an electric filter for filtering low frequencies in order to protect an electronic circuit from ESD.

A high-pass filter (1) for filtering low frequencies is used in the signal path between an antenna connector (2) and an electrical circuit (3) in a communication unit. Via the antenna connector different antennas may be connected. The high-pass filter (1) for filtering low frequencies is erected with a capacitance (C1) in the serial path and a inductance (L1) in the parallel path. The high-pass filter (1) allows the protection of the following electrical circuit (3).

As an further aspect the high-pass filter has a cutoff frequency lower than the lowest cutoff frequency of a radio frequency separator in the electrical circuit (3).

## Description

The invention relates to an electric filter for filtering low frequencies in order to protect an electronic circuit from high voltage pulses. Further the invention relates to the protection of an electric circuit in a communication unit.

It is known in the prior art to build up a communication unit, e.g. a mobile phone with a first main antenna connector and a further antenna connector to add an additional antenna. The first and main antenna is in general provided together with the phone as such and is in general most of the time in connection. The further antenna, e.g. an external antenna for use in a car environment is mainly not attached and will only be connected to the communication unit in case of the special use, e.g. while driving in the car. However, the antenna connector has to be easily accessible to offer the possibility to have a quick attachment of the further antenna. Therefore antennas are mainly either screwed in or plugged in via the additional antenna connector and is located at the outer surface of the communication unit ("Originalzubehör: Erhöhen Sie den Nutzen Ihres Ericsson Mobiltelefons" by: Ericsson 1997).

The antenna connector at the outer surface is an interface highly insusceptible to high voltage pulses e.g. electro static discharge (ESD). ESD may degrade receiver sensitivity and may degrade the output power. Further to this ESD may cause damage of components in the communication unit.

Further to this, so called dual band mobile phones are more and more available in the market. For example a dual band mobile phone is able to work with two different frequencies. E.g. with 900 MHz and 1800 MHz or with 900 MHz and 1900 MHz. In the area of low band and also within high band receivers the same problems as mentioned before with ESD may occur, because of the use of surface acoustic filters. In order to reduce the sensitivity against ESD, non-linear components can be added into the signal path. A non-linear component can be a diode or a varistor or spark gaps.

Adding non-linear components could cause the generation of harmonics in the transmitter path. Large tolerances of the actual values of there capacitances, inductances and resistances are leading to varying losses and hence varying receiver sensitivity.

Further to this any additional component causes additional losses and degrading receiver sensitivity and output power. Additional losses are due to power dissipation because of a limited Q factor of the components or due to mismatch introduced by these components.

Therefore it is an object of the present invention to provide an electrical filter that reduces the electro static discharge sensitivity without providing additional losses and any harmonic generation.

This is achieved by the teaching of claim 1.

According to claim 1 it is advantageous that ESD protection is provided for low band frequencies and for high band frequencies or any other frequency in between.

Further to this it is advantageous that the electrical filter could either be built up from discrete components or is integrated.

Further it is advantageous that the electric filter for ESD protection is easy to implement and does not need any further, e.g. mechanical means to protect. This further results in the advantage that a user of, e.g. a mobile phone does not have to handle the protection by himself, as it is already available without any further handling of protection means by the user.

Further advantageous embodiments are included in the claim 2 - 21.

According to claim 15 it is advantageous as the discrete components could be arranged close to the antenna connector. This protects the electronic circuit even more from any high voltage pulse.

According to claim 16 and 17 it is advantageous to use a single multi-layer component, as the high-pass filter components integrated in a multilayer circuit or a thin film component respectively can be individually matched to the low-pass filter branch and the high-pass filter branch. Therefore less design restrictions due to limited element values occur. Further to this in case it is built of the same material, the same temperature and variations thereof occur at all components.

In the following the invention will be further described according to the figures and by means of examples. The following figures show:
Fig. 1a: A schematic block diagram including claim 1,
Fig. 1b: a semi-schematic block diagram of a signal path of a dual band mobile phone,
Fig. 2: a graphical illustration of the characteristic performance output curves V2 and V3 from a Diplexer,
Fig.3a: a simulated normalized ESD pulse,
Fig. 3b: a simulated normalized ESD pulse and the resulting pulse response on the output ports of a Diplexer with the use of the invention,
Fig. 4: a second semi schematic block diagram of a signal path of a dual band mobile phone.

Identically labeled elements like components and ports appearing in different ones of the figures refer to the same element.

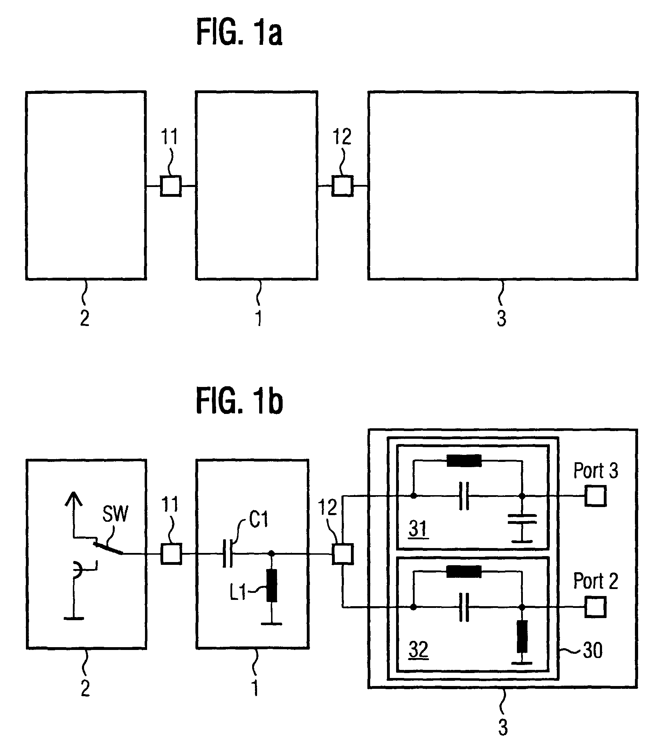

In the following the invention will be further described by means of Fig.1a and Fig.1b.

An antenna connector 2 for connecting an antenna and an electrical circuit 3 are connected via a signal path. The antenna connector 2 is connected via a port 11 to the signal path, whereas an antenna connector can be used to either connect one single antenna or to connect an internal and an external antenna as well. In cases when an internal and an external antenna are connected and should be used, an additional antenna switch SW is necessary to switch between the internal and external antenna. This is shown in Fig. 1b where the antenna switch SW is part of the antenna connector 2. A further port 12 is provided to connect the electrical circuit 3 to the signal path.

Further to this, figure 1b shows a semi-schematic block diagram, wherein in a preferred embodiment the very first component of the electrical circuit 3, connected via port 12 to the signal path, is a Diplexer 30. Here a typical Diplexer 30 arrangement with a low-pass-filter branch 31, e.g. for separation a 900 MHz band with the corresponding output port 3 and a high-pass-filter branch 32 for separation of a 1800 MHz bandwidth the corresponding output port 2, are shown. As a Diplexer arrangement is well known in the prior art, the Diplexer arrangement shown is only chosen by example. That special arrangement of the Diplexer 30 is described in the specification for "Dual band (GSM-DCS1800) Chip Multilayer Frequency Separator SLF-090EN from Hitachi Metals, Ltd., Tottori Works".

However it has to be mentioned again that the choice of a Diplexer arrangement as the electrical circuit should not limit the scope of the invention. However, a Triplexer or any similar arrangement could be used here as well. The invention can be used for every conceivable case where it is necessary to protect an electrical circuit against high voltage pulses from the antenna connector.

Further to this a high-pass-filter can be used for an electrical circuit 3 where the very first element is a single band separator or a n-band separator, wherein n means 1,2,3,... multiple used bands, like GSM 900 with the bandwidth of 890 MHz to 960 MHz, or GSM 1800 with the bandwidth of 1710 MHz to 1880MHz, or PCS 1900 with the bandwidth of 1850 MHz to 1990 MHz. Further to this the previous arrangement can also be used in combination where the very first elements in a electrical circuit is a single mode or a n-mode separator, wherein n means 1,2,3,... multiple used modes, like GSM, AMPS, IS-95, DECT, Satellite Phones or UMTS. It should be mentioned that the very first element of such a electrical circuit also could be any kind of switch matrix like a Transmit/Receive switch, or any kind of transmitter or receiver circuit for radio signal processing.

One possible realization of the invention could be the use in a PC environment, where a card phone, e.g. a PCMCIA card phone, is inserted and the card phone uses any of the above mentioned different modes or standards.

In the preferred embodiment the electrical filter for ESD protection, as shown in Fig 1b, is a high-pass filter consisting of a first capacitor C1 and a first inductor L1. The capacitance C1 is connected in series to the signal path and provides a DC-decoupling between the common antenna connection 11 and the electrical circuit port 12. The inductor L1 is connected in between the common signal path and ground and provides the main effect on ESD protection. An incoming ESD pulse is first differentiated at C1 and then short-circuited to ground by L1. The energy short-circuited to ground depends strongly on the inductivity and the factor Q of L1. Therefore a careful design of C1 and L1 has to be done in a way to reduce the ESD pulse down to a non-dangerous level as well as provide the lowest insertion possible. Of course, the high-pass consisting of C1 and L1 is the very simple high-pass-filter and a high-pass-characteristic can also be realized with additional capacitances, inductances or resistances and thus improving the ESD protection. Further to this the serial and parallel path there provide additional line loss, characterized by resistance or any parasitic capacitance or inductance. Anywhere either the capacitance or the inductance can be replaced by a resistor R to get a high-pass-filter characteristic.

According to one preferred arrangement, as described before, the very first component of the electrical circuit 3 in a dual-band mobile phone is the Diplexer 30. The Diplexer 30 could either be realized with discrete elements or as a single multi-layer component or as a thin film component. That means that such a Diplexer 30 is one unit, including all necessary elements and this unit is realized with the same materials, also described for example in the specification for "Dual band (GSM-DCS 1800) Chip Multilayer Frequency Separator SLF-090EN from Hitachi Metals, Ltd., Tottori Works".

A further aspect of the present invention is that a high-pass-filter 1 can also be included in such a Diplexer 30. All elements of that high-pass-filter 1 are as well realized with the same materials as the elements from the Diplexer 30, which leads to further advantages. In fact the high-pass-filter 1 and the Diplexer 30 could be seen as one new unit with the input port, and the output port 2 and a port 3. The advantage of such a new unit is that no more discrete elements are needed for realization.

However, also a combination of discrete and multi-layer components are applicable and may be used to realize a high-pass-filter. This could be realized for example as follows, the capacitance from the serial path is a discrete element whereas the inductance from the parallel path is realized within a multi-layer component of the following Diplexer, but every other combination is conceivable.

It is one further aspect of the present invention that it is also possible to build in elements from the high-pass-filter in a unit with a multi-layer component like a switch matrix, e.g. in a Transmit/Receive-Switch made of GaAs material.

In a preferred embodiment a high-pass filter 1 is realized with a capacitance value of 6.8 pF for C1 and an inductance value of 0.015µH for L1. Also a state of the art Diplexer 30 as described in the specification for "Dual band (GSM-DCS 1800) Chip Multilayer Frequency Separator SLF-090EN from Hitachi Metals, Ltd., Tottori Works" is used. However, it should be mentioned here that this is only chosen by example and gives one possible choice of values.

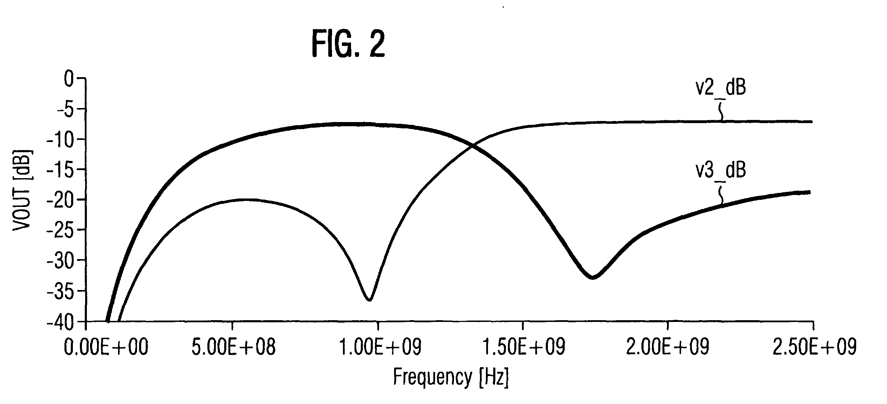

In the following the invention will be further described by means of figure 2.

Fig.2 shows the characteristic performance output curves from port 2 and port 3 for the previous described arrangement that is shown in figure 1b. The x-axis shows the frequency FREQUENCY measured in Hertz and the y-axis the voltage VOUT. Finally in Fig.2 two curves can be seen where V2_dB denotes the voltage at the output port 2 of the high-pass filter branch and V3_dB denotes the voltage at the output port 3 of the low-pass filter branch. The cut-off frequency for the, according to the invention, added high-pass-filter 1 is 498 MHz. The cut off frequency of that high-pass-filter is lower than the lowest frequency from both Diplexer filter branches. This means the greater the distance between the cut-off frequency of the additional high-pass-filter 1 to the cut off frequencies of the Diplexer 30, the lower the influence and in fact the attenuation of the high-band-filter to the Diplexer.
In the previously chosen example the attenuation is lower than 0,3 dB.

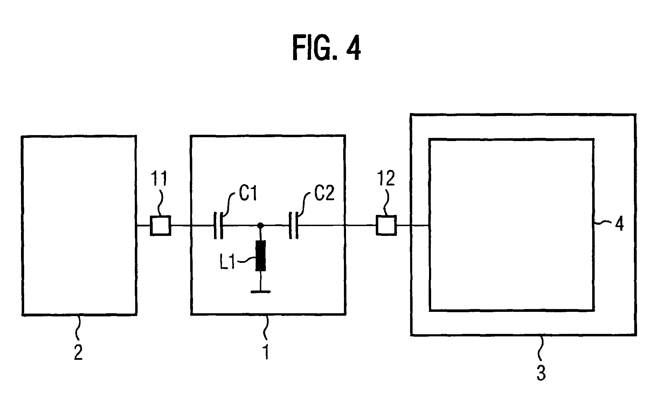

In another preferred embodiment according to figure 4 a high-pass-filter is used in combination with a Transmit/Receive switch as the very first component of an electrical circuit within a GSM 900/1800 dual band mobile phone. Here the high-pass filter 1 is realized with a capacitance value of 22 pF for C1 and an inductance value of 0.1 µH for L1, and a capacitance value of 22 pF for a additional C2 in the serial path. The combination of such a high-pass-filter 1 in the signal path from the antenna connector 2 to the very first element, here the Transmit/Receive switch 4, of an electrical circuit 3 is shown in Fig.4.

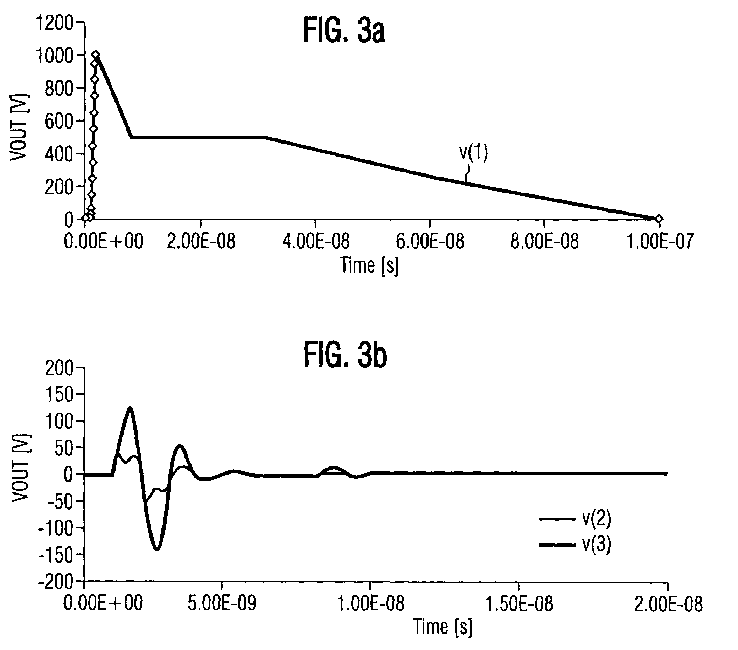

In the following figures 3a and 3b, the x-axis refers to the time TIME in seconds and the y-axis to the voltage VOUT at the different ports. Further to this the numbering v(1) means the voltage at port 1, as known from the previous figures and v(2) and v(3) for the voltage at the port 2 and 3 respectively.

In Fig. 3a a simulated normalized ESD pulse, similar to the waveform of the output signal of an ESD generator is shown. The waveform characteristic of such a normalized ESD pulse is well described in the International Standard IEC 61000-4-2, 1995-01. Fig. 3b shows the improvement in ESD protection that can be achieved with the previously chosen configuration. In case of the previously mentioned Diplexer 30 with the given values, the ESD pulse propagates through the low-pass filter branch 31 of the Diplexer 30 with almost no attenuation. The ESD pulse through the high-pass filter branch 32 is reduced by a factor of approximately 2.5. In the case as presented above the ESD pulse through the low-pass filter branch 31 is reduced by a factor of approximately 8, the ESD pulse through the high-pass filter branch 32 is also reduced by a factor of approximately 8.
Furthermore it has to be mentioned again that the invention is not restricted to the specific embodiments and examples described in the present application. That is, on the basis of the teaching contained in the description, various modifications and variations of the invention may be carried out.

## Claims

1. An electrical filter for filtering low frequencies for protection of an electrical circuit from high voltage pulses,
wherein the electrical filter is inserted in series in a signal path between an antenna connector (2) and an electrical circuit (3) including a radio frequency separator, and with the electrical filter (3) comprising a high-pass filter with a cutoff frequency that is lower than the lowest cutoff frequency of the radio frequency separator within the electrical circuit.

2. The electrical filter according to claim 1,
wherein the antenna connector (2) and the electrical circuit (3) are part of a communication unit.

3. The electrical filter according to claim 2,
wherein said communication unit is a mobile phone.

4. The electrical filter according to claim 3,
wherein said mobile phone is a single band or n-band mobile phone with n=1,2,3,...

5. The electrical filter according to claim 3,
wherein said mobile phone is a single mode or n-mode mobile phone with n=1,2,3,...

6. The electrical filter according to claim 2,
wherein said communication unit is a cordless phone.

7. The electrical filter according to claim 2,
wherein said communication unit is a satellite phone.

8. The electrical filter according to claim 2
wherein said communication unit is a card phone.

9. The electrical filter as claimed in any of the preceding claims 3-8,
wherein said radio frequency separator separates at least two different radio frequencies.

10. A communication unit according to claim 2,
wherein the first part of the electrical circuit (3) is a radio signal filter or a Transmit/Receive-switch or a radio signal transmitter or receiver input.

11. The high-pass-filter according to claim 2,
wherein said high-pass-filter includes at least one capacitance in the serial path and at least one inductance in the parallel path.

12. The high-pass-filter as recited in claim 2,
wherein said high-pass-filter includes at least one capacitance in the serial path and at least one resistance in the parallel path.

13. The high-pass-filter as recited in claim 2,
wherein said high-pass-filter includes at least one resistance in the serial path and at least one inductance in the parallel path.

14. A high-pass-filter according to claim 11-13,
wherein said high-pass-filter includes a combination of the previous claimed components for the serial and parallel path.

15. The high-pass-filter according to claim 11-14,
wherein said high-pass-filter is realized with discrete components in the signal path between the antenna connector and the electrical circuit.

16. The high-pass-filter according to claim 11-14,
wherein said high-pass-filter is integrated within a radio frequency separator unit as a single multi-layer component.

17. The high-pass-filter according to claim 11-14,
wherein said high-pass-filter is integrated within a radio frequency separator unit as a thin film component.

18. The high-pass-filter according to claim 15 or 17,
wherein the high-pass-filter and the radio frequency separator consist of the same material

19. The electrical filter according to claim 11-14,
wherein said high-pass-filter is realized as a combination of discrete components and multi-layer or thin film components.

20. The electrical filter according to claim 4,
wherein the high pass-filter is a configuration with one capacitor in the serial path and one inductor in the parallel path and wherein the very first element in the electrical circuit is a Diplexer for a dual-band phone.

21. The electrical filter according to claim 4,
wherein the high pass-filter is a configuration with one capacitor in the serial path and one inductor in the parallel path and
wherein the very first element in the electrical circuit is a Transmit/Receive switch for a dual band phone.
